# EUROPÄISCHE PATENTSCHRIFT

(11) **EP 2 252 641 B1**
(45) Veröffentlichungstag und Bekanntmachung des Hinweises auf die Patenterteilung: **12.06.2019**
(21) Anmeldenummer: 09717901.4
(22) Anmeldetag: 22.01.2009
(51) Int. Cl.: C08G 59/40, C08G 59/42, C08G 73/06, C08K 3/00, C08L 79/04, H01L 23/29

(54) **HÄRTBARES REAKTIONSHARZSYSTEM**
CURABLE REACTION RESIN SYSTEM
SYSTÈME DE RÉSINE RÉACTIVE DURCISSABLE

(30) Priorität: 07.03.2008 DE 102008013231
(43) Veröffentlichungstag der Anmeldung: 24.11.2010
(73) Patentinhaber: Robert Bosch GmbH, 70442 Stuttgart (DE); SEG Automotive Germany GmbH, 70499 Stuttgart (DE)
(72) Erfinder: SPITZ, Richard, 72766 Reutlingen (DE); JENNRICH, Irene, 71364 Winnenden (DE); ZOLLER, Hubert, 72770 Reutlingen (DE); STAUDENMAIER, Hans, 71334 Waiblingen (DE)
(86) Internationale Anmeldenummer: PCT/EP2009/050720
(87) Internationale Veröffentlichungsnummer: WO 2009/109413

(56) Entgegenhaltungen:
- DE-A1- 10 345 139
- DE-A1- 10 360 895
- US-B1- 6 469 074

## Beschreibung

### Stand der Technik

Die Erfindung bezieht sich auf ein härtbares Reaktionsharzsystem, auf dessen Verwendung und auf ein Verfahren zur Herstellung von Bauteilen unter Anwendung desselben nach dem Oberbegriff der unabhängigen Ansprüche.

Härtbare Reaktionsharzsysteme finden eine breite Anwendung bei der Herstellung von elektronischen oder elektrischen Bauteilen. So werden beispielsweise elektronische Bauteile mittels hochgefüllter Reaktionsharzsysteme umhüllt, um das Bauteil sowohl während der Herstellung als auch im späteren Betrieb vor Umgebungseinflüssen wirkungsvoll zu schützen. Weiterhin werden derartige Reaktionsharzsysteme zur elektrischen Isolation elektrischer oder elektronischer Bauteile wie beispielsweise Zündspulen oder Leistungsdioden eingesetzt. Als Reaktionsharzsysteme kamen bisher insbesondere Harzsysteme auf Epoxidbasis, die als Ein- oder Zweikomponentensysteme ausgeführt sind, zum Einsatz.

Darüber hinaus sind aus der DE 103 60 895 A1 Polymerzusammensetzungen bekannt, die auf Basis einer Polycyanuratmatrix ausgeführt sind und zusätzlich Füllstoffkomponenten sowie Zähigkeitsvermittlerkomponenten umfassen. Im Zuge einer fortschreitenden Miniaturisierung elektrischer bzw. elektronischer Bauteile kommt es während des Betriebes derselben jedoch zu deutlich erhöhten thermischen Belastungen der Bauteile und somit auch der darin vorgesehenen Harzsysteme. Dies führt zu einem Bedarf an hochtemperaturstabilen, härtbaren Reaktionsharzsystemen.

Weiterhin sind aus der US 6,469,074 B1 Einkomponentenzusammensetzungen enthaltend Epoxidverbindungen und eine Cyanatesterkomponente bekannt.

### Offenbarung der Erfindung

Der vorliegenden Erfindung liegt die Aufgabe zugrunde, ein härtbares Reaktionsharzsystem bereitzustellen, das eine ausreichende elektrische Isolationswirkung bei gleichzeitig hoher Temperaturbeständigkeit aufweist und dennoch gut zu verarbeiten ist.

Die der Erfindung zugrunde liegende Aufgabe wird erfindungsgemäß durch die Bereitstellung eines härtbaren Reaktionsharzsystems gelöst, das als Zweikomponentensystem einsetzbar ist und bei dessen Konzeption auf den Einsatz von Epoxidharzen weitgehend verzichtet wird. Dabei ist mindestens eine, bei alternativen Ausführungsformen sogar beide Harzkomponenten des Zweikomponentensystems epoxidfrei gehalten. Auf diese Weise lassen sich deutlich höhere Glasübergangstemperaturen im Vergleich zu bisherigen Epoxidharzmassen erreichen.

Mit den in den Unteransprüchen aufgeführten Maßnahmen sind vorteilhafte Weiterbildungen des erfindungsgemäßen Reaktionsharzsystems möglich.

So ist insbesondere von Vorteil, dass das härtbare Reaktionsharzsystem als erste Reaktionsharzkomponente eine Dispersion eines sogenannten Modifiers oder Zähigkeitsvermittlers in einem epoxidharzfreien Harzsystem enthält. Da üblicherweise der Einsatz von Modifiern in Form einer den entsprechenden Modifier und ein Epoxidharz enthaltenden Dispersion erfolgt, ist dessen Bereitstellung in einem epoxidfreien Harz auf Cyanatesterbasis ein vorteilhafter Schritt zu höheren Glasübergangstemperaturen des ausgehärteten Reaktionsharzsystems.

Weiterhin ist von Vorteil, wenn die erste Reaktionsharzkomponente des härtbaren Reaktionsharzsystems einen Füllstoff enthält, der insbesondere in Form von amorphem Siliziumdioxid gegebenenfalls unter Zusatz von Aluminiumoxid ausgeführt ist. Auf diese Weise ist eine gute Isolationswirkung des resultierenden Reaktionsharzsystems gewährleistet. Weiterhin kommt es aufgrund des geringen Wärmeausdehnungskoeffizienten des Füllstoffs bei starker Erwärmung nur zu einer relativ geringen Ausdehnung des Harzsystems in ausgehärtetem Zustand.

Gemäß einer besonders vorteilhaften Ausführungsform ist als zweite Reaktionsharzkomponente eine Lösung bzw. Dispersion eines Vernetzungskatalysators mit einem geeigneten Harz vorgesehen. Hierbei wird bewusst auf den üblichen Einsatz von Nonylphenol verzichtet, da dieses toxikologisch kritisch zu bewerten ist.

Während der Verarbeitung des erfindungsgemäßen Reaktionsharzsystems ist es von Vorteil, wenn dieses vor der eigentlichen Verarbeitung in Form zweier getrennter Harzkomponenten gelagert und mindestens eine dieser Harzkomponenten auf einen pH-Wert >7, also im basischen Bereich stabilisiert wird. Dies erhöht die Lagerstabilität der Reaktionharzkomponenten wesentlich.

Es ist weiterhin von Vorteil, wenn die Lagerung bei einer Temperatur von < 80°C erfolgt, da in diesem Temperaturbereich auch über einen längeren Zeitraum nur eine geringe Viskositätszunahme der beiden Harzkomponenten zu beobachten ist.

Das beschriebene Reaktionsharzsystem lässt sich vorteilhafterweise zur Fertigung von Leistungsdioden, Halbleiterbauteilen, Generatoren, Zündspulen, Hybridwechselrichtern und Bauteilen für Ventile oder Elektromotoren verwenden.

### Ausführungsformen der Erfindung

Ein Reaktionsharzsystem gemäß vorliegender Erfindung ist vorzugsweise als Zweikomponentensystem ausgeführt. Dies bedeutet, dass das Reaktionsharzsystem zwei Reaktionsharzkomponenten A1, A2 umfasst, die verschiedene Inhaltsstoffe aufweisen, wobei beide Reaktionsharzkomponenten getrennt voneinander gelagert und erst unmittelbar vor der eigentlichen Verarbeitung bzw. Anwendung des Reaktionsharzsystems miteinander vermischt und verarbeitet werden. Bei frühzeitiger Vermischung beider Komponenten würde es zu einer unerwünscht frühzeitigen Aushärtung des Reaktionsharzsystems kommen.

Eine erste Reaktionsharzkomponente A1 umfasst bspw. drei Grundkomponenten, nämlich eine Harzkomponente A, Polymerpartikel C und einen Füllstoff D, wobei der Zusatz der Polymerpartikel C optional ist und anwendungsbezogen erfolgt. Darüber hinaus können übliche Additive wie beispielweise Entschäumer, Sedimentationshemmer oder Haftvermittler enthalten sein.

Die erste Reaktionsharzkomponente A1 ist vorzugsweise frei von Epoxidharzen ausgeführt, wobei als Harzkomponente A ersatzweise ein Harz auf Basis eines oder mehrerer Cyanatester gewählt wird. Diese Polycyanuratmatrix umfasst vorzugsweise phenylgruppenhaltige Monomere sowie mehrfach cyanatesterguppenhaltige Verbindungen.

So eignen sich beispielsweise Harze auf der Basis von Polyphenolcyanaten wie Oligo(3-methylen-1,5-phenylencyanat) sowie Cyanatester auf Basis von Novolaken, Cyanatester auf der Basis von 4,4 Ethylidendiphenyldicyanat und auf der Basis von Ethyliden-bis-4,1-phenyldicyanat.

Die Harzkomponente A ist in der ersten Reaktionsharzkomponente A1 mit einem Anteil von 25 bis 50 Gew.%, vorzugsweise mit einem Anteil von 28 bis 42 Gew.% und insbesondere mit einem Anteil von 27 bis 35 Gew.% enthalten. Als Harzkomponente A können sowohl Cyanatester, die lediglich auf der Basis eines der genannten Monomere ausgeführt sind, berücksichtigt werden; die Harzkomponente A kann jedoch auch aus Mischungen der genannten Monomere gebildet sein.

Als weitere Komponente enthält die Reaktionsharzkomponente A1 mindestens einen Modifier bzw. eine Zähigkeitsvermittlerkomponente C, die verhindert, dass das Reaktionsharzsystem im ausgehärteten Zustand einen überwiegend spröden Charakter annimmt. Dabei handelt es sich insbesondere um polysiloxanhaltige Polymere oder um Silicone, die bspw. in Form einer die Silikonpartikel und die Harzkomponente A enthaltenden Dispersion zum Einsatz kommen können.

Diese kann in situ erzeugt werden, indem zunächst eine Emulsion eines Siloxans in einem Harz auf Cyanatesterbasis der Reaktionsharzkomponente A1 zugesetzt wird. Bei einem nachfolgenden Aushärtungsschritt der Reaktionsharzkomponente A1 bilden sich bei Anwesenheit geeigneter Additive, insbesondere Katalysatoren, unter anderem Partikel bzw. Nanopartikel aus Silicon, die als Modifier C dienen. Diese Siliconpartikel können grundsätzlich eine chemisch modifizierte bzw. Oberfläche aufweisen.

Die Reaktionsharzkomponente A1 enthält beispielsweise 0,5 bis 11 Gew.% an Siliconen bzw. Polysiloxanen, vorzugsweise 1 bis 7 Gew.% und insbesondere 2 bis 5 Gew.%.

Weiterhin enthält die Reaktionsharzkomponente A1 vorzugsweise einen mineralischen Füllstoff D, durch dessen geeignete Wahl der Schwund des Reaktionsharzsystems während der Aushärtung verringert werden kann und wodurch sich die thermische Stabilität bzw. die elektrische Isolierwirkung des ausgehärteten Reaktionsharzsystems erhöht. Als Füllstoffmaterialien eignen sich beispielsweise Aluminiumoxid, Kreide, Siliciumcarbid, Bornitrid, Talkum, Quarzmehl, Quarzgut oder Mischungen derselben. Besonders bevorzugt ist die Verwendung von Aluminiumoxid und Quarzgut sowie Mischungen derselben, da auf diese Weise eine besonders geringe Ausdehnung des Reaktionsharzsystems während der Aushärtung erreicht werden kann. Vorzugsweise ist der Füllstoff D in Form von amorphem Siliciumdioxid unter Zusatz von Aluminiumoxid ausgeführt. Der Füllstoff D kann auch in Form von Nanopartikeln eingesetzt werden.

Der Füllstoffanteil in der Reaktionsharzkomponente A1 beträgt beispielsweise 20 bis 65 Gew.%, vorzugsweise 35 bis 63 Gew.% und insbesondere 51 bis 61 Gew.%.

Das Reaktionsharzsystem umfasst im nicht ausgehärteten Zustand eine weitere Reaktionsharzkomponente A2. Diese enthält bspw. einen in einer geeigneten weiteren Harzkomponente Aw dispergierten Katalysator B. Als Katalysator B kommen insbesondere Übergangsmetall-Komplexverbindungen wie beispielsweise Kupfer-, Cobalt- oder Mangan-Acetylacetonate zum Einsatz.

Aus toxikologischen Gründen wird dabei auf den Einsatz von Nonylphenol als Träger für den entsprechenden Katalysator B verzichtet. Stattdessen wird als Harzkomponente Aw der zweiten Reaktionsharzkomponente A2 ein hochreines Epoxidharz beispielsweise auf der Basis von Bisphenol F eingesetzt oder die in der Reaktionsharzkomponente A1 verwendete Harzkomponente A bzw. Kresylglycid, Silane oder Mischungen dieser Harze.

Der Anteil an Katalysator B in der weiteren Reaktionsharzkomponente A2 beträgt 0,1 bis 10 Gew.%, vorzugsweise 0,3 bis 8 Gew.% und insbesondere 0,4 bis 5 Gew.%.

Die Reaktionsharzkomponenten A1, A2 werden zunächst als lagerstabile Vormischungen in einem Dissolver hergestellt. Eine mögliche Lagerung der Reaktionsharzkomponenten A1, A2 erfolgt vorzugsweise bei Temperaturen < 80°C, um eine vorzeitige Erhöhung der Viskosität der Reaktionsharzkomponenten A1, A2 zu vermeiden. Weiterhin wird während der Lagerung der Reaktionsharzkomponenten A1, A2 der pH-Wert mindestens einer Reaktionsharzkomponente A1, A2 im basischen Bereich, also in einem Bereich > 7 gehalten. Darüber hinaus sind die Reaktionsharzkomponenten A1, A2 zur Langzeitstabilisierung frei von flüssigen Sedimentationshemmern gestaltet und unter Verzicht auf den Zusatz saurer Füllstoffe. Es werden in diesem Fall bevorzugt oberflächensilanisierte Füllstoffderivate eingesetzt.

Das Reaktionsharzsystem wird in einen verarbeitungsfertigen Zustand gebracht, in dem die Reaktionsharzkomponenten A1, A2 vermischt werden. Dies geschieht beispielsweise mit Hilfe einer vollautomatischen Zweikomponenten-Misch/ Dosieranlage. Dabei wird eine Verarbeitungstemperatur von vorzugsweise 60 - 110°C eingehalten, da insbesondere die Reaktionsharzkomponente A1 aufgrund des hohen Füllgrades eine relativ hohe Ausgangsviskosität aufweist. Das Mischungsverhältnis beider Reaktionsharzkomponenten A1 : A2 beträgt bspw. 100 : 0,5 - 100 : 10, vorzugsweise 100 : 1 - 100 : 5 und insbesondere 100 : 1,5 - 100 : 2,5.

Exemplarisch werden im Folgenden Ausführungsbeispiele von Reaktionsharzsystemen bzw. deren Zusammensetzung in Gewichtsprozent und das dabei resultierende Eigenschaftsprofil im ausgehärteten Zustand wiedergegeben.

| | **Ausführungsbeispiel 1** | **Ausführungsbeispiel 2** | **Ausführungsbeispiel 3** | **Ausführungsbeispiel 4** | **Ausführungsbeispiel 5** | **Ausführungsbeispiel 6** | **Ausführungsbeispiel 7** |
|---|---|---|---|---|---|---|---|
| **Reaktionsharzkomponente A1** | | | | | | | |
| **Harzkomponente A** | Cyanatester Basis Novolak | Oligo(3-methylen-1,5-phenylencyanat + 4,4 Ethylidendiphenyl dicyanat | Oligo(3-methylen-1,5-phenylencyanat + Ethyliden-bis -4,1-phenyldicyanat | Oligo(3-methylen-1,5-phenylencyanat | Oligo(3-methylen-1,5-phenylencyanat | Oligo(3-methylen-1,5-phenylencyanat + Ethyliden-bis -4,1-phenyldicyanat | Oligo(3-methylen-1,5-phenylencyanat |
| **Harzanteil** | 34 % | 29 % + 5,1 % ∑ = 34,1 % | 28,8 % + 3,2 % ∑ = 32 % | 27,4 % | 27,3 % | 26,94 % + 1,35 % =28,29 % | 34 % |
| **Modifier** | --- | --- | --- | 2,5 % Silicon in 3,8 % Harz (4,4 Ethylidenediphenyl dicyanat) | 2,7% Silicon in 4,1 % Harz (4,4 Ethylidenediphenyl dicyanat) | 2,7 % Silicon in 4,04 % Harz (Ethyliden-bis-4,1-phenylendicyanat) | |
| **Additive** | 1,3 % | 1,3 % | 1,3 % | 1,4 % | 1,4 % | 1,34 % | 1,4 % |
| **amorphes SiO2** | 58,1 % | 57,6 % | 60,5 % | 58 % | 57,7 % | 56,9 % | 58 % |
| **Al₂O₃** | 6,6 % | 7 % | 6,2 % | 6,9 % | 6,8 % | 6,73 % | 6,6 % |

| **Reaktionsharzkomponente A2** | |
|---|---|
| **Kataysator** | 0,7% ige Mischung von Cu- bzw. Co-Acetylacetonaten in Epoxidharz auf Basis Bisphenol F |

Das Mischungsverhältnis von Reaktionsharzkomponente A1 zu Reaktionsharzkomponente A2 beträgt bei allen genannten Ausführungsbeispielen A1 /A2 = 100/2 Gewichtsteile.

Die obengenannten Zusammensetzungen ergeben folgendes Eigenschaftsprofile:

| Ausführungs beispiel | α¹ 10-6 1/°C | Tg °C | Schwund % | Bruchspannung² N/mm² | Bruchdehnung ² % |
|---|---|---|---|---|---|
| 1 | bis 260°C 22 | 280 | | 106 | 0,8 |
| 2 | bis 254°C 22 | 286 | 0,6 | 101 / 51 | 0,82 / 0,38 |
| 3 | bis 265°C 25 | 265 | 0,45 | 109 / 49 | 0,87 / 0,34 |
| 4 | bis 248°C 28 | 271 | 0,4 | 98 / 49 | 0,96 / 0,4 |
| 6 | bis 245°C 28 | 273 | 0,1 | 96 / 39 | 0,9 / 0,3 |
| 7 | bis 223°C 26 | 250 | | 119 | 0,97 / 0,3 |

| | | | | | |
|---|---|---|---|---|---|
| ¹⁾ thermischer Ausdehnungskoeffizient ²⁾ Biege- / bzw. Zugversuch | | | | | |

Das Reaktionsharzsystem eignet sich aufgrund seiner thermischen Stabilität im ausgehärteten Zustand vor allem für Bauteile, die zeitweise Temperaturen von über 270°C ausgesetzt sind.

So kann das erfindungsgemäße Reaktionsharzsystem beispielsweise verwendet werden zur Herstellung von Vergussmassen für Leistungsdioden, Generatoren, Hybrid-Wechselrichtern oder Zündspulen, von Glob-Tops, Underfillern, Moldmassen oder Hochtemperaturklebstoffen für Halbleiterbauteile, oder zur Herstellung von medienbeständige Schutz- und Barriereschichten für Halbleiter, Siliziumchips, Flip-Chip-Unterlagen oder luftdichte Baugruppen, sowie zur Herstellung von Bauteilen für Ventile oder Elektromotoren.

## Patentansprüche

1. Härtbares Reaktionsharzsystem, insbesondere Vergussmasse, Moldmasse oder Hochtemperaturharz, das als Zweikomponentenmasse zu verarbeiten ist und eine erste Reaktionsharzkomponente (A1) sowie eine zweite Reaktionsharzkomponente (A2) umfasst, **dadurch gekennzeichnet, dass** die erste Reaktionsharzkomponente (A1) epoxidfrei und auf Basis eines Cyanatesters ausgeführt ist, dass die erste Reaktionsharzkomponente (A1) einen Modifier auf Basis eines Silikons oder Siloxans enthält, und dass der Modifier in Form einer Emulsion von Siloxanen in einem Harz auf Cyanatesterbasis vorliegt.

2. Reaktionsharzsystem nach Anspruch 1, **dadurch gekennzeichnet, dass** die erste Reaktionsharzkomponente (A1) einen Modifier auf Basis eines Silikons oder Siloxans enthält.

3. Reaktionsharzsystem nach Anspruch 2, **dadurch gekennzeichnet, dass** der Modifier in Form einer Emulsion von Siloxanen in einem Harz auf Cyanatesterbasis vorliegt.

4. Reaktionsharzsystem nach Anspruch 1 oder 2, **dadurch gekennzeichnet, dass** die erste Reaktionsharzkomponente (A1) einen Füllstoff (D) enthält.

5. Reaktionsharzsystem nach Anspruch 4, **dadurch gekennzeichnet, dass** der Füllstoff (D) amorphes Siliciumdioxid und/oder Aluminiumoxid enthält.

6. Reaktionsharzsystem nach einem der vorhergehenden Ansprüche, **dadurch gekennzeichnet, dass** die zweite Reaktionsharzkomponente (A2) einen Vernetzungskatalysator D enthält.

7. Reaktionsharzsystem nach einem der vorhergehenden Ansprüche, **dadurch gekennzeichnet, dass** die zweite Reaktionsharzkomponente (A2) ein Epoxidharz auf Basis Bisphenol F, ein Silan oder ein Kresylglycid enthält.

8. Ausgehärtetes Zweikomponenten-Reaktionsharzsystem, insbesondere Isoliermasse, Glob-Top, Underfiller oder Schutzschicht, hergestellt mittels eines Reaktionharzsystems nach einem der vorhergehenden Ansprüche, **dadurch gekennzeichnet, dass** es auf Basis von Cyanatestern ausgeführt ist und einen Epoxidharzanteil von < 3,5 Gew.% aufweist.

9. Ausgehärtetes Reaktionsharzsystem nach Anspruch 8, **dadurch gekennzeichnet, dass** als Modifier C Silikon- oder Polysiloxanelastomerpartikel enthalten sind.

10. Verfahren zur Herstellung von Bauteilen unter Verwendung eines Reaktionsharzsystems nach einem der Ansprüche 1 bis 7, **dadurch gekennzeichnet, dass** das Reaktionsharzsystem bis zur Verarbeitung in Form von zwei getrennten Reaktionsharzkomponenten (A1, A2) gelagert wird, **dadurch gekennzeichnet, dass** der pH-Wert mindestens einer Reaktionsharzkomponente (A1,A2) während der Lagerung auf einen Wert > 7 stabilisiert wird, die beiden Reaktionsharzkomponenten (A1, A2) unmittelbar vor der Verarbeitung gemischt und dann in das Bauteil eingebracht werden.

11. Verfahren nach Anspruch 10, **dadurch gekennzeichnet**, das die Lagerung der Reaktionsharzkomponenten (A1, A2) bei einer Temperatur von < 80°C erfolgt.

12. Verwendung eines Reaktionsharzsystems nach einem der Ansprüche 1 bis 9 zur Herstellung von Leistungsdioden, Halbleiterbauteilen, Generatoren, Zündspulen, Hybrid-Wechselrichtern und Bauteilen für Ventile oder Elektromotoren.

## Claims

1. Curable reactive-resin system, especially encapsulating compound, moulding compound or high-temperature resin, which is to be processed as a two-component composition and comprises a first reactive-resin component (A1) and also a second reactive-resin component (A2), **characterized in that** the first reactive-resin component (A1) is epoxide-free and configured on the basis of a cyanate ester, **in that** the first reactive-resin component (A1) comprises a modifier based on a silicone or siloxane, and **in that** the modifier is in the form of an emulsion of siloxanes in a cyanate ester-based resin.

2. Reactive-resin system according to Claim 1, **characterized in that** the first reactive-resin component (A1) comprises a modifier based on a silicone or siloxane.

3. Reactive-resin system according to Claim 2, **characterized in that** the modifier is in the form of an emulsion of siloxanes in a cyanate ester-based resin.

4. Reactive-resin system according to Claim 1 or 2, **characterized in that** the first reactive-resin component (A1) comprises a filler (D).

5. Reactive-resin system according to Claim 4, **characterized in that** the filler (D) comprises amorphous silicon-dioxide and/or aluminium oxide.

6. Reactive-resin system according to any of the preceding claims, **characterized in that** the second reactive-resin component (A2) comprises a crosslinking catalyst D.

7. Reactive-resin system according to any of the preceding claims, **characterized in that** the second reactive-resin component (A2) comprises an epoxy resin based on bisphenol F, a silane or a cresyl glycide.

8. Cured two-component reactive-resin system, especially insulating compound, glob-top, under-filler or protective layer, produced by means of a reactive-resin system according to any of the preceding claims, **characterized in that** it is configured on the basis of cyanate esters and has an epoxy resin fraction of < 3.5% by weight.

9. Cured reactive-resin system according to Claim 8, **characterized in that** particles of silicone or polysiloxane elastomer are included as modifiers C.

10. Method for producing components using a reactive-resin system according to any of Claims 1 to 7, **characterized in that** the reactive-resin system until processing is stored in the form of two separate reactive-resin components (A1, A2), **characterized in that** the pH at least of one reactive-resin component (A1, A2) is stabilized during storage to a value > 7, the two reactive-resin components (A1, A2) are mixed immediately prior to processing and then introduced into the component.

11. Method according to Claim 10, **characterized in that** the reactive-resin components (A1, A2) are stored at a temperature of < 80°C.

12. Use of a reactive-resin system according to any of Claims 1 to 9 for producing power diodes, semiconductor components, generators, ignition coils, hybrid inverters and components for valves or electric motors.

## Revendications

1. Système de résine réactive durcissable, en particulier masse de coulée, masse de moulage ou résine haute température, qui est à mettre en oeuvre sous forme de masse à deux composants et qui comprend un premier composant de résine réactive (A1) ainsi qu'un deuxième composant de résine réactive (A2), **caractérisé en ce que** le premier composant de résine réactive (A1) est exempt d'époxy et est à base d'un ester de type cyanate, **en ce que** le premier composant de résine réactive (A1) contient un agent de modification à base d'une silicone ou d'un siloxane et **en ce que** l'agent de modification se trouve sous forme d'une émulsion de siloxanes dans une résine à base d'ester de type cyanate.

2. Système de résine réactive selon la revendication 1, **caractérisé en ce que** le premier composant de résine réactive (A1) contient un agent de modification à base d'une silicone ou d'un siloxane.

3. Système de résine réactive selon la revendication 2, **caractérisé en ce que** l'agent de modification se trouve sous forme d'une émulsion de siloxanes dans une résine à base d'ester de type cyanate.

4. Système de résine réactive selon la revendication 1 ou 2, **caractérisé en ce que** le premier composant de résine réactive (A1) contient une charge (D).

5. Système de résine réactive selon la revendication 4, **caractérisé en ce que** la charge (D) contient du dioxyde de silicium amorphe et/ou de l'oxyde d'aluminium amorphe.

6. Système de résine réactive selon l'une quelconque des revendications précédentes, **caractérisé en ce que** le deuxième composant de résine réactive (A2) contient un catalyseur de réticulation D.

7. Système de résine réactive selon l'une quelconque des revendications précédentes, **caractérisé en ce que** le deuxième composant de résine réactive (A2) contient une résine époxyde à base de bisphénol F, un silane ou un glycide de crésyle.

8. Système de résine réactive à deux composants, durci, en particulier masse d'isolation, "Glob-Top", matière de remplissage sous-jacente ou couche de protection, préparé au moyen d'un système de résine réactive selon l'une quelconque des revendications précédentes, **caractérisé en ce qu'**il est réalisé à base d'esters de type cyanate et présente une proportion de résine époxyde < 3,5% en poids.

9. Système de résine réactive, durci, selon la revendication 8, **caractérisé en ce que** des particules d'élastomère de silicone ou de polysiloxane sont contenues comme agent de modification C.

10. Procédé pour la fabrication de pièces à l'aide d'un système de résine réactive selon l'une quelconque des revendications 1 à 7, **caractérisé en ce que** le système de résine réactive est stocké jusqu'à la mise en oeuvre sous forme de deux composants de résine réactive séparés (A1, A2), **caractérisé en ce que** le pH d'au moins un composant de résine réactive (A1, A2) pendant le stockage est stabilisé à une valeur > 7, les deux composants de résine réactive (A1, A2) sont mélangés directement avant la mise en oeuvre et ensuite introduits dans la pièce.

11. Procédé selon la revendication 10, **caractérisé en ce que** le stockage des composants de résine réactive (A1, A2) a lieu à une température < 80°C.

12. Utilisation d'un système de résine réactive selon l'une quelconque des revendications 1 à 9 pour la fabrication de diodes de puissance, de pièces semiconductrices, de générateurs, de bobines d'allumage, d'onduleurs hybrides et des pièces pour des soupapes ou des moteurs électriques.
